# EUROPEAN PATENT APPLICATION

(11) **EP 4 664 168 A1**
(43) Date of publication of application: **17.12.2025**
(21) Application number: 24305916.9
(22) Date of filing: 11.06.2024
(51) Int. Cl.: G02B 6/12, H01S 5/40, H01S 5/343, H01S 5/02, H01L 23/00, H01S 5/227, H01S 5/22, H01S 5/0239, H10F 30/221, H10F 30/222

(54) **SEMICONDUCTOR DEVICE AND SEMICONDUCTOR DEVICE FABRICATION METHOD**

(71) Applicant: Nokia Solutions and Networks Oy, 02610 Espoo (FI)
(72) Inventor: BESANCON, Claire, 75014 Paris (FR); DECOBERT, Jean, 91620 Nozay (FR)
(74) Representative: Novagraaf Technologies

(57) **Abstract**

There is provided a semiconductor device (100) comprising a silicon substrate (102) having a silica layer (104) thereon. One or more laser structures (106) are on the silica layer, wherein the one or more laser structures comprise layered III-V materials. Photonic components are arranged in the silica layer, and the one or more photonic components comprise at least one of: a modulator (126) or a germanium photodiode (128). There is also provided a semiconductor device (400) comprising a silicon substrate (402) having a silica layer (404) thereon. The silicon substrate is a silicon-based readout integrated circuit substrate. A short-wavelength infrared photodiode structure is on the silica layer, wherein the short-wavelength infrared photodiode comprises layered III-V materials. There is also provided a semiconductor device fabrication method.

## Description

### Field

Examples of the present disclosure relates to semiconductor devices and semiconductor device fabrication methods.

### Background

Silicon-on-insulator (SOI) technology is important to silicon photonics. However, there are challenges in integrating III-V materials into such technology in order to exploit the beneficial characteristics of both SOI and III-V materials.

An objective of the present disclosure is to address such challenges, amongst others.

### Summary

In a first exemplary aspect, there is provided a semiconductor device comprising:
a silicon substrate having a silica layer thereon; and
one or more laser structures on the silica layer, wherein the one or more laser structures comprise layered III-V materials, and the layered III-V materials comprise an n-type doped InP layer on the silica layer, a quantum well layer on the n-type doped InP layer, a p-type doped InP layer on the quantum well layer, and a p-type doped InGaAs layer on the p-type doped InP layer;
wherein the one or more laser structures further comprise a semi-insulating III-V material extending at least partially along and at least partially surrounding the quantum well layer, the p-type doped InP layer and the p-type doped InGaAs layer; and
wherein one or more photonic components are arranged in the silica layer, and the one or more photonic components comprise at least one of: a modulator or a germanium photodiode.

Optionally, the modulator is a silicon-based modulator.

Optionally, the one or more laser structures are buried in an encasing layer arranged on the silica layer.

Optionally, the one more photonic components arranged in the silica layer further comprise one or more waveguides disposed in a position aligned with and below the one or more laser structures in the silica layer in a direction toward the silicon substrate.

Optionally, the modulator is a PN junction modulator.

Optionally, the one or more laser structures are a plurality of laser structures configured as a coarse wavelength division multiplexer.

In a second exemplary aspect, there is provided a semiconductor device comprising:
a silicon substrate having a silica layer thereon, wherein the silicon substrate is a silicon-based readout integrated circuit substrate; and
a short-wavelength infrared photodiode structure on the silica layer, wherein the short-wavelength infrared photodiode comprises layered III-V materials, wherein the layered III-V materials comprise:
   a first InP layer on the silica layer;
   an InGaAs layer on the first InP layer;
   a second InP layer on the InGaAs layer; and
   one or more InP regions embedded in the second InP layer;
   wherein the first InP layer has heavy n-type doping, the second InP layer has light n-type doping, and the one or more InP regions have heavy p-type doping.

In a third exemplary aspect, there is provided a semiconductor device fabrication method, the method comprising:
providing a first silicon substrate having a first silica layer thereon, and layered III-V materials on the first silica layer;
depositing a layer of adhesive on the layered III-V materials;
bonding a second silicon substrate to the layer of adhesive;
removing the first silicon substrate;
providing a third silicon substrate, the third silicon substrate having a second silica layer thereon;
bonding the first silica layer to the second silica layer; and
removing the second silicon substrate and the adhesive from the layered III-V materials.

Optionally, the layered III-V materials form one or more laser structures.

Optionally, the layered III-V materials forming the one or more laser structures comprise:
an n-type doped InP layer on the first silica layer;
a quantum well layer on the n-type doped InP layer;
a p-type doped InP layer on the quantum well layer; and
a p-type doped InGaAs layer on the p-type doped InP layer.

Optionally, one or more photonic components are arranged in the second silica layer, and the one or more photonic components comprise at least one of: a modulator or a germanium photodiode.

Optionally, the one or more photonic components arranged in the second silica layer further comprise one or more waveguides.

Optionally, the third silicon substrate is a silicon-based readout integrated circuit substrate, and the plurality of III-V material layers form a short-wavelength infrared photodiode, wherein the plurality if III-V material layers comprise:
a first InP layer on the first silica layer;
an InGaAs layer on the first InP layer;
a second InP layer on the InGaAs layer; and
one or more InP regions embedded in the second InP layer;
wherein the first InP layer has heavy n-type doping, the second InP layer has light n-type doping, and the one or more InP regions have heavy p-type doping.

Optionally, bonding the first silica layer to the second silica layer comprises bonding the first silica layer to the second silica layer with hydrophilic wafer bonding.

Optionally, removing the first silicon substrate comprises selectively etching the first silicon substrate from the first silica layer, and the method further comprises planarizing the first silica layer after the first silicon substrate is etched from the first silica layer.

### Brief Description of Drawings

Examples of the disclosure are now described, with reference to the drawings, in which:
FIGS. 1A and 1B are cross-sectional views of a schematic diagram of a first type of semiconductor device;
FIGS. 2A to 2F are diagrams of an exemplary method for fabricating the semiconductor device of FIG. 1B;
FIGS. 3A to 3F are diagrams of an exemplary method of fabricating a first silicon substrate having a first silica layer thereon, and layered III-V materials on the first silica layer;
FIG. 4 is a cross-sectional view of a schematic diagram of a second type of semiconductor device;
FIGS. 5A to 5E are diagrams of an exemplary method for fabricating the semiconductor device of FIG. 4; and
FIG. 6 is a flow chart of a semiconductor device fabrication method that corresponds to the semiconductor device fabrication methods described with reference to FIGS. 2A to 2F and 5A to 5E.

### Detailed Description

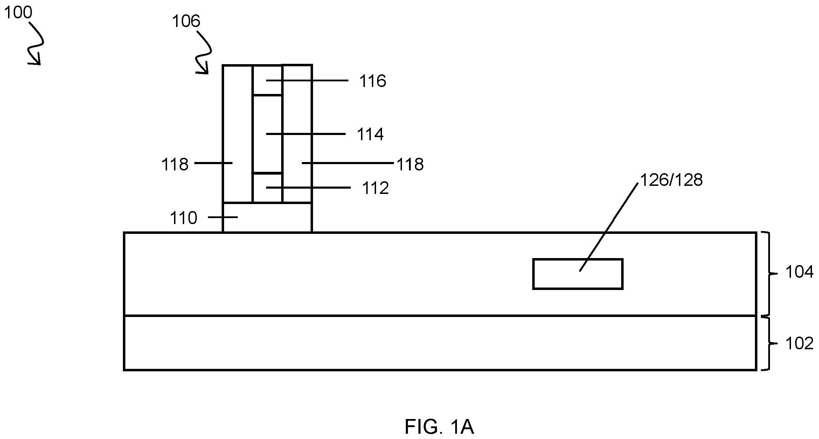

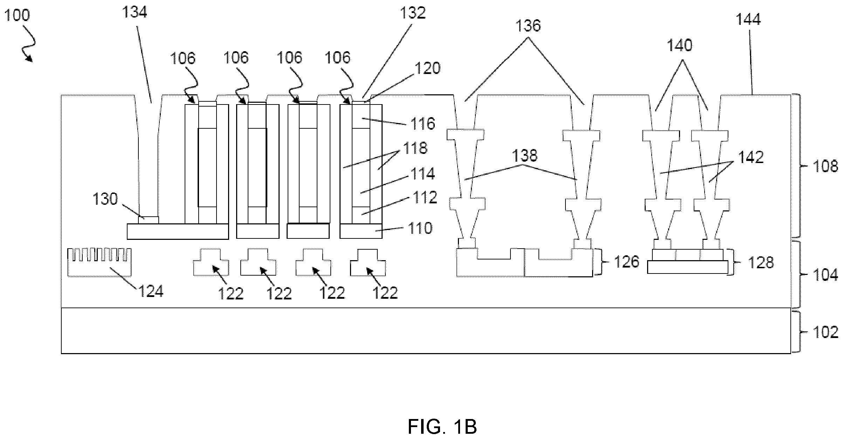

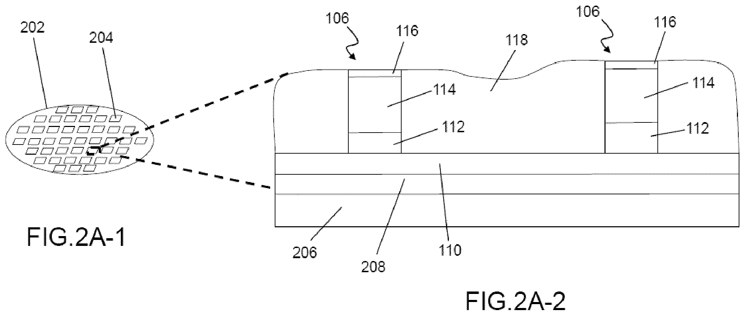

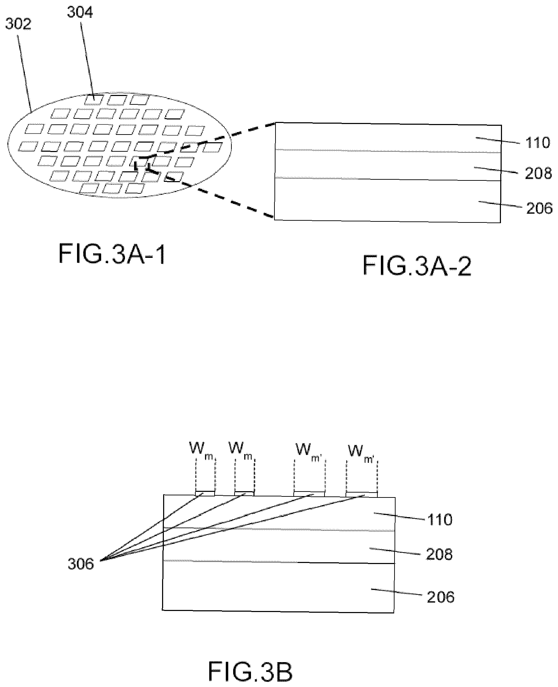

FIGS. 1A and 1B are cross-sectional views of a schematic diagram of a first type of semiconductor device 100. FIGS. 2A to 2F, and 3A to 3F are diagrams of exemplary methods involved in fabricating the semiconductor device 100 of FIGS. 1A and 1B. This is an example of a 4-channel coarse wavelength division modulation (CWDM) system, and the fabrication thereof, involving the integration of InP-based laser structures coupled to silicon photonics functions through a 300 mm compatible process while limiting the thermal budget on silicon photonics functions.

FIG. 1A is a cross-sectional view of a schematic diagram of a first type of semiconductor device 100. The semiconductor device 100 comprises a silicon substrate 102 having a silica layer 104 thereon. One or more laser structures 106 are arranged on the silica layer 104. The one or more laser structures 106 comprise layered III-V materials, and the layered III-V materials comprise an n-type doped InP layer 110 on the silica layer 104, a quantum well layer 112 on the n-type doped InP layer 110, a p-type doped InP layer 114 on the quantum well layer 112, and a p-type doped InGaAs layer 116 on the p-type doped InP layer 114.

The one or more laser structures further comprise a semi-insulating III-V material 118 extending at least partially along and at least partially surrounding the quantum well layer 112, the p-type doped InP layer 114 and the p-type doped InGaAs layer 116.

One or more photonic components 126/128 are arranged in the silica layer 104. The one or more photonic components 126/128 comprise at least one of a modulator or a germanium photodiode.

Turning to FIG. 1B, the semiconductor device 100 of FIG. 1A is shown, but with further features included. Common reference numerals denote common features. The semiconductor device 100 is a III-V silicon-on-insulator (SOI) CWDM system. This example is a 4-channel CWDM system, with four laser structures 106; however, any suitable number of channels can be used. This exemplary device includes the 4-channel laser array coupled to one or more modulators 126 (which can be silicon based, for example), and can also include a receptor part with one or more photodiodes 128 (which can be one or more germanium based photodiodes, for example).

The device 100 comprises a silicon substrate 102 with a silica layer 104 thereon.

The aforementioned laser structures 106 are arranged on the silica layer 104. The laser structures 106 comprise layered III-V materials.

For each of the laser structures 106, the layered III-V materials comprise an n-type doped InP layer 110 arranged on the silica layer 104.

A quantum well layer 112 is then arranged on the n-type doped InP layer 110.

The quantum well layer 112 can have a width that is smaller than a width on the n-type doped InP layer 110. In context, width is defined in the direction substantially perpendicular to the stacking direction of the III-V layers. The quantum well layer 112 may partially cover the n-type doped InP layer 110, such that extremities of the n-type doped InP layer 110 in the width direction are not covered by the quantum layer 112.

The thickness of the quantum well layer 112 can be controlled to define the laser wavelength of the laser structure. The laser structures 106 of the laser array can have a different thicknesses for their respective quantum well layers 112, to provide different laser wavelengths in the laser array.

The quantum well layer 112 can be a single quantum well layer or a multiple quantum well layer. The quantum well layer can comprise III-V semiconductor materials, such as a AlₓGa_{y}In_{1-x-y}As or GaₓIn₁₋ₓAs_{1-y}P_{y} multi quantum well based active region (with 0<=x, y<=1), for example.

A p-type doped InP layer 114 is arranged on the quantum well layer 112.

The p-type doped InP layer 114 can have substantially the same width, and be aligned with, the quantum well layer 112.

A p-type doped InGaAs layer 116 is arranged on the p-type doped InP layer 114.

The p-type doped InGaAs layer 116 can have substantially the same width, and be aligned with, the p-type doped InP layer 114.

The III-V materials are layered with a stacking direction that is a direction away from the silicon substrate 102.

Each of the laser structures 106 can further comprise a semi-insulating III-V material 118 extending at least partially along and at least partially surrounding the quantum well layer 112, the p-type doped InP layer 114 and the p-type doped InGaAs layer 116. The semi-insulating III-V material 118 can be arranged on the n-type doped InP layer 110.

The semi-insulating III-V material 118 can improve the heat dissipation of the laser array. In an example, the semi-insulating III-V material 118 can be semi-insulating InP.

Photonic components are arranged in the silica layer 104. These photonic components comprise at least one of a modulator 126 or a photodiode 128.

The modulator 126 can be one or more modulators, and can be a PN junction modulator(s). The photodiode 128 can be one or more photodiodes, and can be a germanium or germanium-based photodiode(s).

These photonic components can be arranged at a position in the silica layer 104 that is laterally displaced away from the laser array. This lateral displacement can be in a direction that is substantially perpendicular to the stacking direction of the III-V materials in the laser structures 106.

The photonic components arranged in the silica layer 104 can further comprise one or more waveguides 122. These waveguides 122 can be disposed in a position aligned with and below the one or more laser structures 106, in the silica layer 104, and in a direction toward the silicon substrate 102. That is, each laser structure 106 can have a respective waveguide 122 positioned underneath it, in the silica layer 104.

The photonic components can also include a grating coupler 124, which can be silicon based. This grating coupler 124 can be laterally displaced away from the laser array. For example, this lateral displacement can be in a direction opposite to the modulator 126 and photodiode 128, with respect to the position of the laser array. In other words, the modulator 126 and photodiode 128 can be in the silica layer 104 on one side of the laser array, and the grating coupler 124 can be in the silica layer 104 on the opposing side of the laser array. Other positionings of these components can be also be realised in/on the silica layer 104.

The laser structures 106 can be buried in an encasing layer 108 arranged on the silica layer 104. The encasing layer 108 can be another silica layer, for example.

A series of openings can be arranged in a first surface 144 of the encasing layer 108. The first surface 144 of the encasing layer 108 can be a surface of the encasing layer 108 that is opposite to a surface of the encasing layer 108 that is arranged on the silica layer 104.

One or more first openings 132 of the series of openings connect to through-holes in the encasing layer 108, wherein these through-holes connect the first openings 132 to each of the laser structures 106. A metallization contact 120 can be arranged in each of these through-holes to provide a contact for each of the laser structures 106.

A second opening 134 of the series of openings connects to a through-hole in the encasing layer 108, wherein this through-hole connects the second opening 134 to the n-type doped InP layer 110 of one of the laser structures. A metallization contact 130 can be arranged in this through-hole to provide a contact to the n-type doped InP layer 110 of the laser structure. Whist only one such second opening 134 and through-hole is shown in FIG. 1B, in alternative arrangements, more one such second opening 134, through-hole and metallization contact 130 could be included, or such a second opening 134, through-hole and metallization contact could be provided for each of the laser structures 106. Alternatively, interconnects between the n-type doped InP layers 110 of each of the laser structures 106 and the second opening 134 and through-hole could be provided.

One or more third openings 136 of the series of openings connect to through-holes in the encasing layer 108, wherein these through-holes connect the third openings 136 to the modulator 126. In the example of FIG. 1B, there are two of these third openings 136 and associated through-holes; however, any suitable number could be used for the number of modulators present. The through-holes can be at least partially filled with a metallization material 138.

One or more fourth openings 140 of the series of openings connect to through-holes in the encasing layer 108, wherein these through-holes connect the fourth openings 140 to the photodiode 128. In the example of FIG. 1B, there are two of these fourth openings 140 and associated through-holes; however, any suitable number could be used for the number of photodiodes present. The through-holes can be at least partially filled with a metallization material 142.

Turning to FIGS. 2A to 2F, an exemplary method for fabricating the semiconductor device 100 of FIG. 1B is presented.

FIG. 2A-1 shows a perspective view of a schematic diagram of an InP on Si (InPOSi) wafer 202, with InP coupons 204 thereon. The InPOSi wafer 202 can be a 300 mm wafer.

FIGS. 2A-2 shows a cross-sectional view of a schematic diagram of an exemplary InP coupon of the InP coupons 204 on the InPOSi wafer 202. In examples, the coupons 204 can have a size of 5 to 10 mm.

Each coupon 204 can comprise one or more laser structures 106. For clarity, only two laser structures 106 are shown. However, any suitable number could be used. A coupon can be considered as a defined region on the wafer in which heterostructures are formed.

Each coupon 204 can have a layered structure on a first silicon substrate 206. The first silicon substrate 206 can be considered as the silicon substrate layer of the InPOSi wafer 202.

The first silicon layer 206 has a first silica layer 208 thereon. Layered III-V materials are arranged on the first silica layer 208 to provide a laser structure 106 consistent with that described with reference to FIG. 1B.

The layered III-V materials of the laser structures comprise the n-type doped InP layer 110 arranged on the first silica layer. The quantum layer 112 is arranged on the InP layer 110. Then, the p-type doped InP layer 114 is arranged on the quantum well layer 112. Then, the p-type doped InGaAs layer 116 is arranged on the p-type doped InP layer 114.

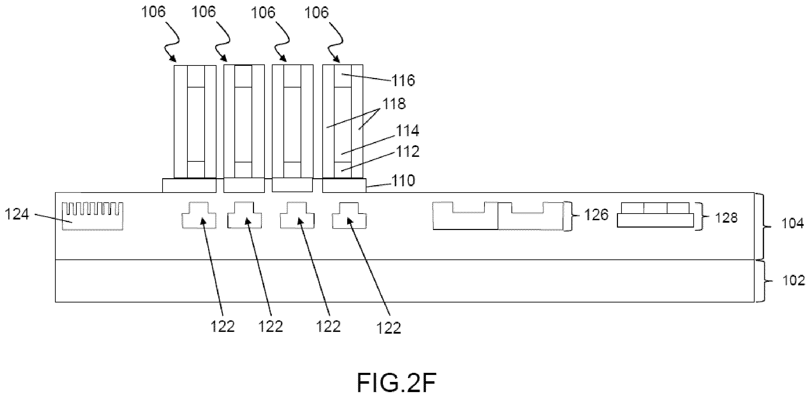

In FIGS. 2A to 2E, a single n-type doped InP layer 110 is shown for all of the laser structures 106; this is for simplicity. The final device can have a separate n-type doped InP layer 110 for each laser structure, serving as a n-type electrode, as per FIG. 1B and FIG. 2F.

The quantum layer 112, the p-type doped InP layer 114 and the p-type doped InGaAs layer 116 can be surrounded by the semi-insulating III-V material 118 which is arranged on the n-type doped InP layer 110.

Exemplary steps for fabricating the structure of FIG. 2A-2 will later be described with reference to FIGS. 3A to 3F.

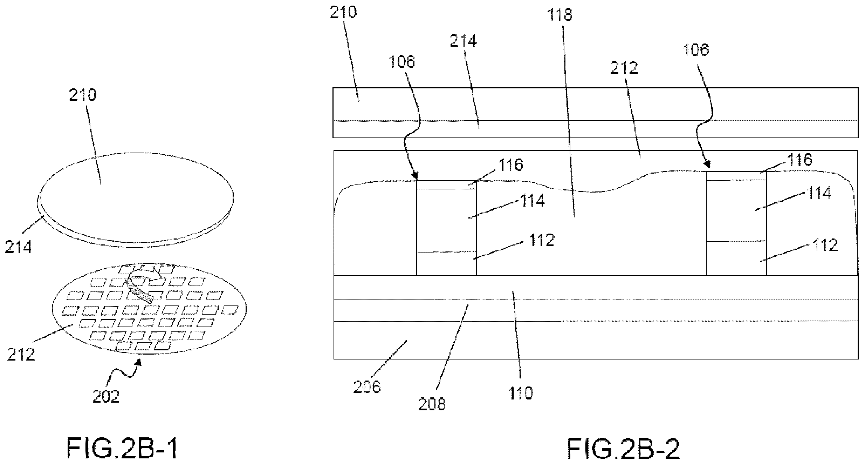

Turning to FIGS. 2B-1 and 2B-2, a first layer of adhesive 212 is deposited on the layered III-V materials. A second silicon substrate 210 is provided, and a second layer of adhesive 214 can be added on the second silicon substrate 210. The second layer of adhesive 214 can substantially cover one of the major faces of the second silicon substrate 210.

The adhesive can be a temporary adhesive. In an example, the adhesive can be benzocyclobutene (BCB).

The second silicon substrate 210 can be a silicon wafer, and in particular a 300 mm silicon wafer to match the size of the InPOSi wafer 202.

FIG 2B-1 shows a perspective view of the schematic diagram of the InPOSi wafer 202 of FIG 2A-1, with the first layer of adhesive 212 deposited thereon, as well as the second silicon substrate 210 with the second layer of adhesive 214 deposited thereon.

FIG 2B-2 shows a cross-sectional view corresponding to FIG 2A-2, with the first layer of adhesive 212 deposited thereon, and the second silicon substrate 210 with the second layer of adhesive 214 thereon.

The first layer of adhesive 212 that is deposited on the layered III-V materials can be deposited substantially across the entire top surface of the InPOSi wafer 202. The top surface can be considered the surface of the layered III-V materials that opposes the surface of the layered III-V materials in contact with the first silica layer 208.

The InPOSi wafer 202 and second silicon substrate 210 can be aligned such that the first layer of adhesive 212 and the second layer of adhesive 214 can be brought into contact with one another to bond the InPOSi wafer 202 to the second silicon substrate 210.

In this way, the second silicon substrate 210 is bonded to the InPOSi wafer above the layered III-V materials. In this context, 'above' means in the direction of stacking of the III-V materials away from the first silicon substrate 206.

In some examples, both the first layer of adhesive 212 and second layer of adhesive 214 are used to bond the InPOSi wafer 202 to the second silicon substrate 210. In other examples, only one of the first layer of adhesive 212 and second layer of adhesive 214 may be used to bond the InPOSi wafer 202 to the second silicon substrate 210.

For the bonding, the two surfaces can be put into contact under vacuum, and the stack can be annealed (for example at 200°C).

When the InPOSi wafer 202 and second silicon substrate 210 are bonded to one another, the first silicon substrate 206 (i.e., the silicon substrate 206 of the InPOSi wafer) is removed.

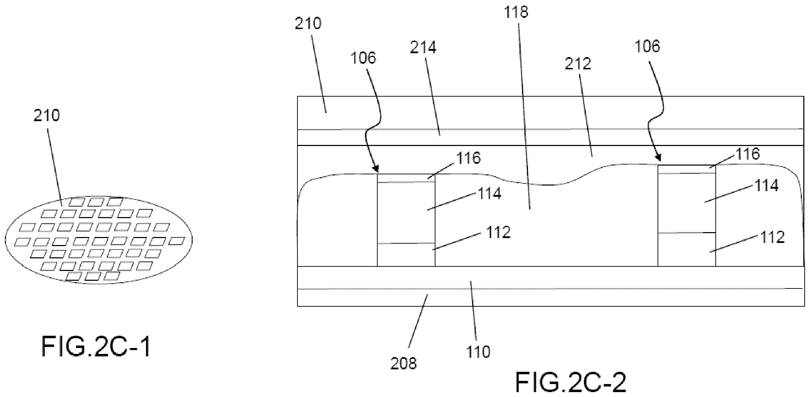

FIG. 2C-1 shows a perspective view of the schematic diagram of the layered III-V structure bonded to the second silicon substrate 210, with the first silicon substrate 206 removed. FIG. 2C-2 shows a cross-sectional view of the schematic diagram of the layered III-V bonded to the second silicon substrate 210, with the first silicon substrate 206 removed.

The first silicon substrate 206 can be removed by selectively etching the first silicon substrate 206 from the first silica layer 208.

The first silica layer 208 can then be planarized after the first silicon substrate 206 is etched from the first silica layer 208. In an example, the etching can be KOH wet etching. The first silica layer 208 can be planarized, for example, to 10-20 nm. In an example, the planarization can be by chemical mechanical polishing.

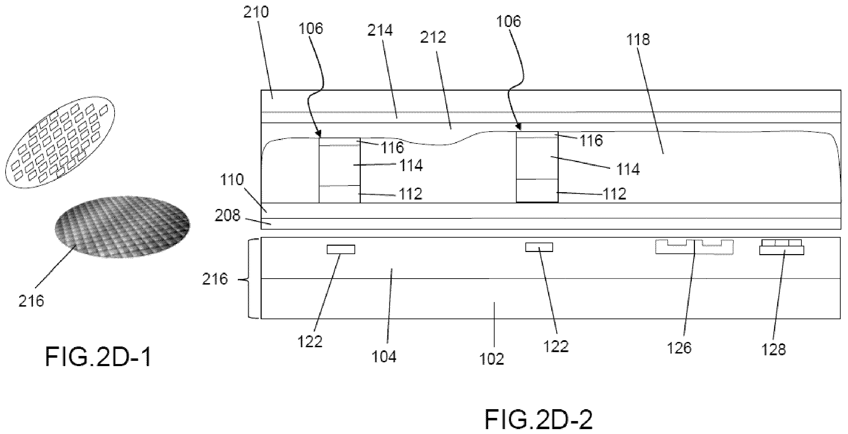

Turning to FIGS. 2D-1 and 2D-2, the first silica layer 208 can be bonded to a third silicon substrate 102 using a back-side die bonding approach.

The third silicon substrate 102 can be of a photonic SOI wafer 216 (e.g., a 300 mm wafer to match the InPOSi wafer 202), wherein the third silicon substrate 102 has a second silica layer 104 thereon. The third silicon substrate 102 corresponds to the silicon substrate 102 of FIG 1. The second silica layer 104 corresponds to the silica layer 104 of FIG. 1B.

At this step, the first silica layer 208 is bonded to the second silica layer 104. When bonded, the combination of the planarized first silica layer 208 and the second silica layer 104 can be considered as corresponding to the silica layer 104 of FIG. 1B.

FIG. 2D-1 shows a perspective view of the schematic diagram of the layered III-V structure that is bonded to the second silicon substrate 210 with the adhesive 212/214, with the first silicon substrate 206 removed, to be bonded to the photonic SOI wafer 216. FIG. 2D-2 shows a cross-sectional view of the schematic diagram of the layered III-V structure that is bonded to the second silicon substrate 210 with the adhesive 212/214, with the first silicon substrate 206 removed, to be bonded the photonic SOI wafer 216.

Die bonding is a type of direct bonding in which the contact of two surfaces creates oxidation and hence covalent bonds. The bonding can be a hydrophilic direct bonding process that utilises the formation of hydrophilic bonds using Van der Waals forces when the two surfaces are in contact. The contact between two surfaces for such bonding, is highly dependent on the roughness and planarity of the two surfaces. Typically, a mean roughness below 1 nm is required for efficient direct bonding. Structures formed by multi-growth steps (such as the laser structures) usually do not meet this criteria for front-side direct bonding. For example, the InPOSi wafer 202 with the laser structures 106 on can have a surface topology of up to around 20 µm.

The solution disclosed herein, uses the second silicon substrate 210 as a temporary substrate in order to etch the first silicon substrate 206, and uses the back side surface of the first silica layer 208 for a direct bonding process to the third silicon substrate 102 (which is the SOI photonic wafer). By planarizing the first silica layer 208, a sufficiently low surface roughness can be achieved for the direct bonding to the second silica layer 104 on the third silicon substrate 102.

In other words, the planarized surface of the first silica layer 208 is die bonded to a surface of the second silica layer 104 on the third silicon substrate 102. The planarized surface of the first silica layer 208 is the surface opposing the surface of the first silica layer 208 on which the III-V laser structure(s) 106 is grown.

One or more photonic components can be arranged in the second silica layer 104. These photonic components can comprise at least one of the modulator 126 or photodiode 128 as discussed with reference to FIG. 1B. For brevity the detail is not repeated here. The photonic components can also include the waveguides 122 and/or grating coupler 124 as described with reference to FIG. 1B. Again, for brevity the detail is not repeated here.

The layered III-V structures adhered to the second silicon substrate 210 can be directly bonded to the photonic SOI wafer 216. Very high precision can be achieved, for example as low as 150 nm. This allows for precise III-V/Si alignment, which is beneficial for efficient light coupling.

After bonding, in order to enhance the covalent bond ratio, a thermal anneal can be applied. For example, the anneal can be at 300°C for 2 hours.

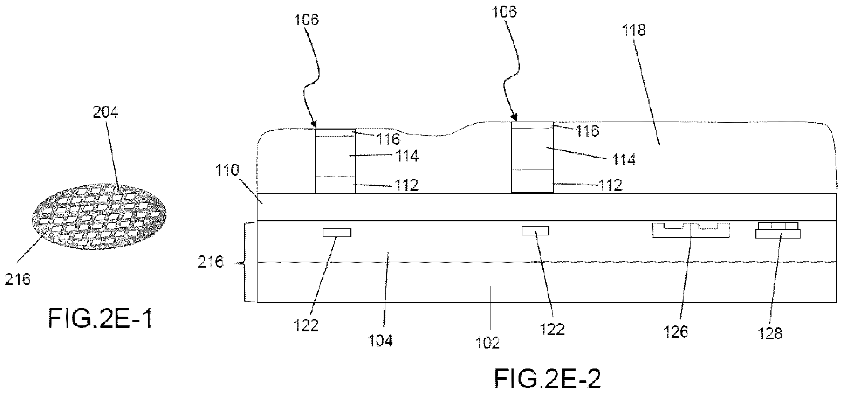

Turning to FIGS 2E-1 and 2E-2, the second silicon substrate 210 and the adhesive 212/214 are removed from the layered III-V materials. The silicon can be removed by KOH wet etching, for example. The adhesive can be removed by selective plasma etching, for example.

FIG. 2E-1 shows a perspective view of the schematic diagram of the laser structures 206 arranged on the photonic SOI wafer 216 with the second silicon substrate and adhesive removed. FIG. 2E-2 shows a cross-sectional view of the schematic diagram of the laser structures 206 arranged on the photonic SOI wafer 216 with the second silicon substrate and adhesive removed.

That is, the InP coupons 104 comprising the laser structures are transferred to the photonic SOI wafer 216.

FIG. 2F shows the laser structures 206 arranged on the photonic SOI wafer 216.

The semi-insulating III-V material 118 can be partially removed so as to conform to the laser structures, as described with reference to FIG. 1B.

It is noted that FIG. 2F shows an example with four laser structures 106 rather than to two of FIGS. 2A to 2E.

Then, the laser structures 106 can be buried in the encasing layer 108, as described with reference to FIG. 1B.

Openings 132, 134, 136, 140 and through-holes can be formed in the encasing layer 108, as described with reference to FIG. 1B, and metallization layers 120, 130, 138, 142 can be deposited, as described with reference to FIG. 1B.

Altogether, this methodology is highly versatile and allows III-V heterostructures grown on an InPOSi wafer to be integrated onto any kind of SOI wafer, from photonic structures to a broader range of structures grown on InPOSi.

This methodology, in which the III-V heterostructures are formed on the InPOSi wafer is advantageous compared to fabricating the III-V stack on an InP wafer for bonding to a silicon wafer (e.g., the photonic SOI wafer 216). In the present methodology, the III-V heterostructure is fabricated on a first silicon substrate 206 (a first silicon wafer). The III-V stack is then bonded to a second silicon substrate 210 (a second silicon wafer), and the first silicon substrate 206 is removed and replaced with a third silicon substrate 102 (the photonic SOI wafer 216) which has photonic components in a silica layer thereon 104. This is beneficial because it allows for the use of a 300 mm silicon wafer rather than the size limited InP wafer for the fabrication of the III-V heterostructures (e.g., the laser structures). In other words, full 300 mm compatibility is provided. Moreover, the transfer from the first silicon wafer to the third silicon wafer (which is the photonic SOI wafer containing the photonic components), via the intermediate second silicon wafer, avoids a step of fabricating the III-V stack directly on the silicon wafer with the photonic components therein/thereon, which have a lower thermal tolerance. That is, higher temperatures can be used when fabricating the III-V heterostructure, without risking any damage to the photonic components in the photonic SOI wafer.

Turning to FIGS. 3A to 3F, an exemplary method of fabricating the first silicon substrate having the first silica layer thereon, and the layered III-V materials of the laser structure(s) on the first silica layer, of FIG. 2A-1 and 2A-2, is presented.

The process begins with an InPOSi wafer 302 with InP coupons thereon.

FIG. 3A-1 shows a perspective view of a schematic diagram of the InPOSi wafer 302, with InP coupons 304 thereon. The InPOSi wafer 302 can be a 300 mm wafer.

FIG. 3A-2 shows a cross-sectional view of a schematic diagram of an exemplary InP coupon of the InP coupons 304 on the InPOSi wafer 302. In examples, the coupons 204 can have a size of 5 to 10 mm.

The InPOSi wafer 302 of FIG. 3A can be considered the same InPOSi wafer 202 of FIG. 2A, and the InP coupons 304 of FIG. 3A can be considered the same InP coupons 204 of FIG. 2A, albeit before the additional III-V layers of the laser structure(s) 106 are grown.

Looking to FIG. 3A-2, the InPOSi wafer is structured as a silicon substrate 206, with a silica layer thereon 208, and an n-type doped InP layer 110 on the silica layer 208, in the same manner as that of FIG. 2A.

Selective area growth (SAG) can then used to grow the multi-wavelength laser array on the InPOSi wafer 302. The SAG can be carried out, for example, using metalorganic vapour-phase epitaxy (MOVPE) systems with selective mask patterns (typically made from silica) that are defined prior to growth, to locally enhance the growth rate of the grown structure. SAG can be used for growth of the quantum well layer to obtain a thickness variation hence photoluminescence (PL) variation between different regions on the same wafer, by varying locally the width of the mask (Wm). Mask widths can change the gas environment during epitaxial growth and lead to the tuning of the growth rate, especially in the short vicinity of such masks. Consequently the thicknesses of the layers can be changed accordingly, meaning that the emission wavelength can be tuned by the mask width.

In an example, from one growth step, a 240 nm wide PL range can obtained due to the growth rate enhancement achieved by SAG.

In an example, the SAG process can be adapted to grow the multi-channel laser array for the CWDM system. The process flow can begin with the deposition of dielectric masks 306 on a full 300 mm InPOSi wafer.

FIG. 3B shows a cross-sectional view of a schematic diagram of the InP coupon of FIG. 3A-2, with the mask(s) 306 added. The mask(s) have two different widths (Wₘ and W_{m'}).

Turning to FIGS. 3C-1 and 3C-2, growth of the quantum well layer 112 is performed.

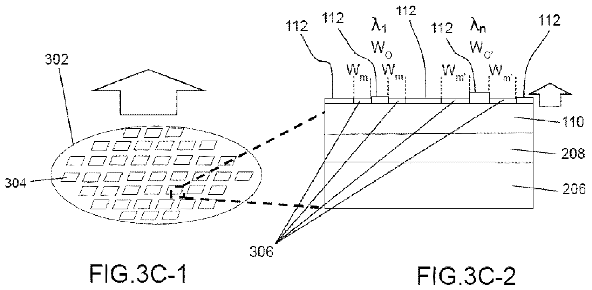

FIG. 3C-1 shows a perspective view of a schematic diagram of the InPOSi wafer 302, with the arrow indicating the direction of growth of the quantum well layer.

FIG. 3C-2 shows a cross-sectional view of a schematic diagram of an exemplary InP coupon of the InP coupons 304 on the InPOSi wafer 302, with the mask 306 applied, and growth of the quantum well layer 112 in the direction indicated by the arrow. The growth happens in a direction opposite to the direction of the substrate from the n-type doped InP layer 110.

The mask 306 allows for the growth to be confined to the openings in the mask. The mask 306 can be used to define different opening sizes (Wₒ and W_{o'}) for thickness variation in the quantum well layer 112, for different laser wavelengths (λ₁ and λₙ).

The space or opening (Wₒ) between the pairs of dielectric stripes of the mask 306 can be set to be between, for example, 20 and 30 µm. The width of the masks (Wₘ) is set for each laser array in order to obtain the desired wavelengths (λ₁...λₙ). The quantum well based active region of each laser structure can be selectively grown onto the large size InPOSi wafer.

Turning to FIGS. 3D-1 and 3D-2, the mask 306 can be etched and the p-type cladding (the p-type doped InP layer 114) can be grown. Then, the p-type doped InGaAs layer 116 can be grown on the p-type doped InP layer 114.

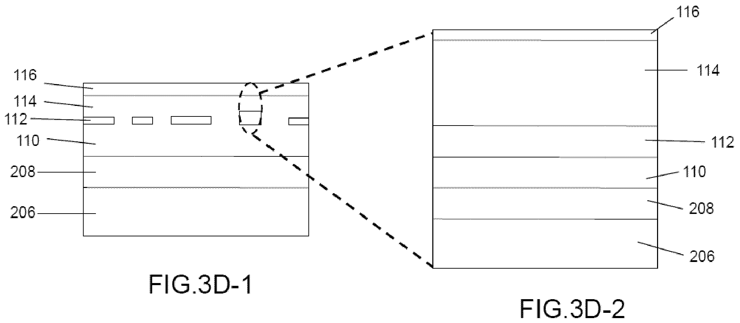

FIG. 3D-1 shows cross-sectional view of a schematic diagram of the exemplary InP coupon with the p-type doped InP layer 114 grown on the quantum well layer 112, and the p-type doped InGaAs layer 116 grown on the p-type doped InP layer 114.

FIG. 3D-2 shows an enhanced view of FIG. 3D-1 for a single laser structure of the InP coupon.

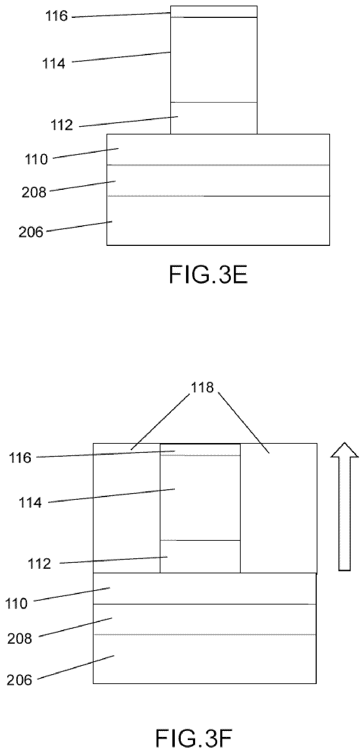

In order to improve the heat dissipation of the III-V laser arrays, each one can be etched and the semi-insulating InP material 118 is grown, as discussed with reference to FIG. 1B. This can be by a semi-insulating buried heterostructure (SIBH) technology. This is depicted in FIGS. 3E and 3F.

Through this exemplary process of FIGS 3A to 3F, the structure of FIG. 2A-1 and FIG. 2A-2 can be achieved for the process of FIGS. 2A to 2F.

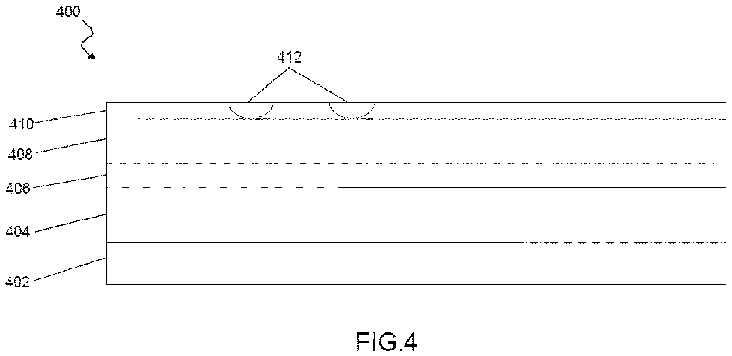

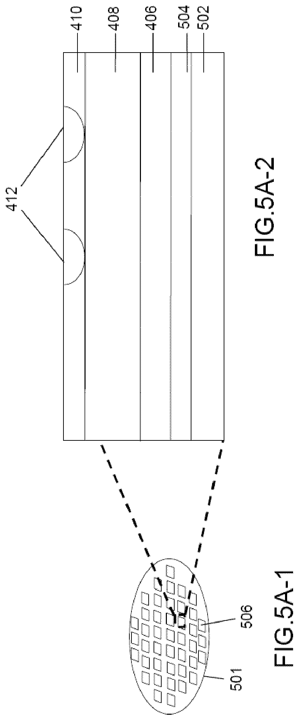

Another example of the back-side die bonding approach described with reference to FIGS. 2A to 2F is in the integration of a InGaAs-based short-wave infrared (SWIR) photodiode onto a CMOS-like SOI wafer. Such a device is shown in FIG. 4, and a fabrication methodology for such a device is described with reference to FIGS. 5A to 5E.

FIG. 4 is a cross-sectional view of a schematic diagram of a second type of semiconductor device. This device can be considered the aforementioned InGaAs - based SWIR on the SOI wafer.

The semiconductor device 400 of FIG. 4 has a silicon substrate 402 with a silica layer 404 thereon. The silicon substrate 402 is a silicon-based readout integrated circuit (ROIC) substrate.

An SWIR photodiode structure is arranged on the silica layer 404, on a side of the silica layer 404 away from the side abutting the silicon substrate 402. The SWIR photodiode comprises layered III-V materials. These III-V layered are layered so as to be stacked in a stacking direction away from the silicon substrate 402.

The layered III-V materials comprise a first InP layer 406 arranged on the silica layer 404. An InGaAs layer 408 is arranged on the first InP layer 406. A second InP layer 410 is arranged on the InGaAs layer 408. One or more InP regions 412 are embedded in the second InP layer 410. In the example of FIG. 4, two InP regions 412 are presented; however, any suitable number could be used. The InP regions are embedded in the second InP layer 410 so as to be exposed in a top surface of the device 400. The top surface can be considered as the surface away from or opposing the silicon substrate 402.

In an example: the first InP layer 406 can have heavy n-type doping, the second InP layer 410 can have light n-type doping, the one or more InP regions 412 can have heavy p-type doping, and the InGaAs layer can light n-type doping.

FIGS. 5A to 5E are diagrams of an exemplary method for fabricating the semiconductor device of FIG. 4.

This approach allows a full 300 mm compatibility from growth, and a high yield collective die bonding process allowing an alignment precision, which can be as low as 150 nm for example.

FIG. 5A-1 shows a perspective view of a schematic diagram of wafer 501 with a plurality of coupons 506 thereon. The wafer 501 can be a 300 mm silicon wafer.

FIG. 5A-2 shows a cross-sectional view of a schematic diagram of one of the coupons of FIG. 5A-1.

The wafer 501 comprises a first silicon substrate 502 having a first silica layer 504 thereon. Layered III-V materials are arranged on the first silica layer 504.

The layered III-V materials form the SWIR photodiode as described with reference to FIG. 4. That is the first InP layer 406 is arranged on the first silica layer 504. The InGaAs layer 408 is arranged on the first InP layer 406. The second InP layer 410 is arranged on the InGaAs layer 408. The one or more InP regions 412 are embedded in the second InP layer 410.

The first silicon substrate 502 and first silica layer 504 are not the silicon-based ROIC substrate 402 and silica layer 404 thereon of FIG. 4, but rather an initial substrate on which the SWIR photodiode can be initially fabricated. The subsequent steps in the process transfer the SWIR photodiode from the first silicon substrate 502 to the silicon-based ROIC substrate 402.

Turning to FIGS 5B-1 and 5B-2, a first layer of adhesive 512 is deposited on the layered III-V materials. A second silicon substrate 510 is provided, and a second layer of adhesive 514 can be added the second silicon substrate 510. The second layer of adhesive 514 can substantially cover one of the major faces of the second silicon substrate 510.

The adhesive can be a temporary adhesive. In an example, the adhesive can be BCB.

The second silicon substrate 510 can be a silicon wafer, and in particular a 300 mm silicon wafer to match the size of the wafer 501 on which the layered III-V materials for the SWIR devices are grown.

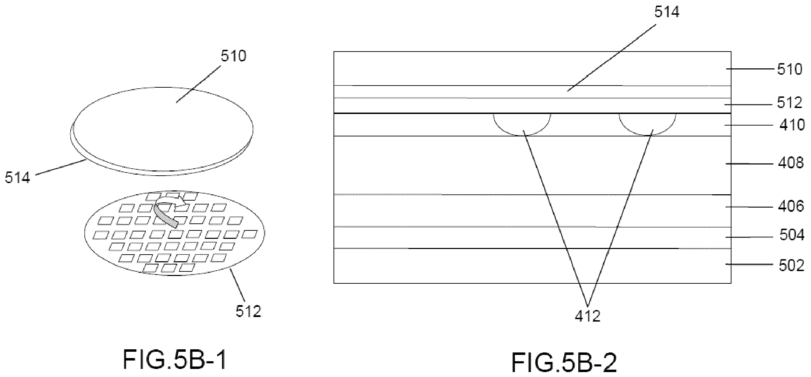

FIG 5B-1 shows a perspective view of the schematic diagram of the wafer 501 with the plurality of coupons 506 thereon, with the first layer of adhesive 512 deposited thereon, as well as the second silicon substrate 510 with the second layer of adhesive 514 deposited thereon.

FIG 5B-2 shows a cross-sectional view corresponding to FIG 5A-2, with the first layer of adhesive 512 deposited on the III-V materials, and the second silicon substrate 510 with the second layer of adhesive 514 thereon.

The first layer of adhesive 512 that is deposited on the layered III-V materials can be deposited substantially across the entire top surface of the wafer 501. The top surface can be considered the surface of the layered III-V materials that opposes the surface of the layered III-V materials in contact with the first silica layer 504.

The wafer 501 and second silicon substrate 510 can be aligned such that the first layer of adhesive 512 and the second layer of adhesive 514 can be brought into contact with one another to bond the wafer 501 to the second silicon substrate 510.

In this way, the second silicon substrate 510 is bonded to the wafer 501 above the layered III-V materials. In this context, 'above' means in the direction of stacking of the III-V materials away from the first silicon substrate 502.

In some examples, both the first layer of adhesive 512 and second layer of adhesive 514 are used to bond the wafer 501 to the second silicon substrate 510. In other examples, only one of the first layer of adhesive 512 and second layer of adhesive 514 may be used to bond the wafer 501 to the second silicon substrate 510.

For the bonding, the two surfaces can be put into contact under vacuum, and the stack can be annealed (for example at 200°C).

When the wafer 501 and second silicon substrate 510 are bonded to one another, the first silicon substrate 502 (i.e., the silicon substrate 502 of the wafer 501) is removed.

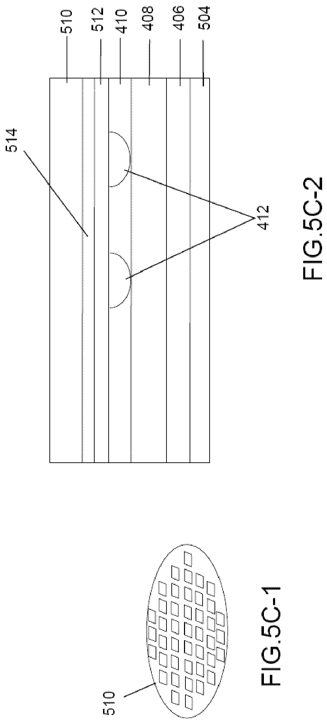

FIG. 5C-1 shows a perspective view of the schematic diagram of the layered III-V structure bonded to the second silicon substrate 510, with the first silicon substrate 502 removed. FIG. 2D-2 shows a cross-sectional view of the schematic diagram of the layered III-V structure bonded to the second silicon substrate 510, with the first silicon substrate 502 removed.

The first silicon substrate 502 can be removed by selectively etching the first silicon substrate 502 from the first silica layer 504. In an example, this etching can be carried out as KOH wet etching.

The first silica layer 504 can then be planarized after the first silicon substrate 502 is etched from the first silica layer 504. The first silica layer 504 can be planarized, for example, to 10-20 nm. In an example, this planarization can be chemical mechanical polishing.

Turning to FIGS. 5D-1 and 5D-2, the first silica layer 504 can be bonded to a third silicon substrate 402 using a back-side die bonding approach.

The third silicon substrate 402 is the silicon-based ROIC substrate 402 of FIG. 4 (this can be on a 300 mm wafer, for full 300 mm compatibility). The third silicon substrate 402 has a second silica layer 404 thereon. The third silicon substrate 402 corresponds to the silicon substrate 402 of FIG 4. The second silica layer 404 corresponds to the silica layer 404 of FIG. 4.

At this step, the first silica layer 504 is bonded to the second silica layer 404. When bonded, the combination of the planarized first silica layer 504 and the second silica layer 404 can be considered as corresponding to the silica layer 404 of FIG. 4.

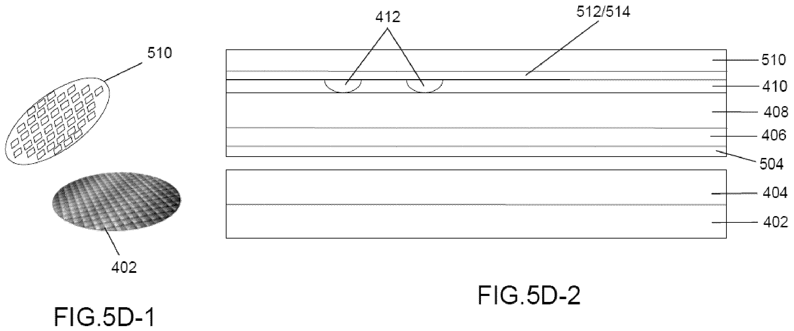

FIG. 5D-1 shows a perspective view of the schematic diagram of the layered III-V structure that has been bonded to the second silicon substrate 510, with the first silicon substrate 502 removed, before being bonded to the third silicon substrate 402. FIG. 5D-2 shows a cross-sectional view of the schematic diagram of the layered III-V structure that has been bonded to the second silicon substrate 510, with the first silicon substrate 502 removed, before being bonded to the third silicon substrate 402.

As discussed with reference to FIG. 2, die bonding is a type of direct bonding in which the contact of two surfaces creates oxidation and hence covalent bonds. The bonding can be a hydrophilic direct bonding process that utilises the formation of hydrophilic bonds using Van der Waals forces when the two surfaces are in contact. The contact between two surfaces for such bonding, is highly dependent on the roughness and planarity of the two surfaces. Typically, a mean roughness below 1 nm is required for efficient direct bonding. Structures formed by multi-growth steps usually do not meet this criteria for front-side direct bonding.

The solution disclosed herein uses the second silicon substrate 510 as a temporary substrate in order to etch the first silicon substrate 506, and uses the back side surface of the first silica layer 504 for a direct bonding process to the third silicon substrate 402 (which is the silicon-based ROIC substrate). By planarizing the first silica layer 504, a sufficiently low surface roughness can be achieved for the direct bonding to the second silica layer 404 of the third silicon substrate 402.

In other words, the planarized surface of the first silica layer 504 is die bonded to a surface of the second silica layer 404 on the third silicon substrate 402. The planarized surface of the first silica layer 504 is the surface opposing the surface of the first silica layer 504 on which the III-V structure of the SWIR is grown.

After bonding, in order to enhance the covalent bond ratio, a thermal anneal can be applied. For example, the anneal can be at 300°C for 2 hours.

Turning to FIGS 5E-1 and 5E-2, the second silicon substrate 510 and the adhesive 512/514 are removed from the layered III-V materials. The silicon can be removed by KOH wet etching, for example. The adhesive can be removed by plasma etching, for example.

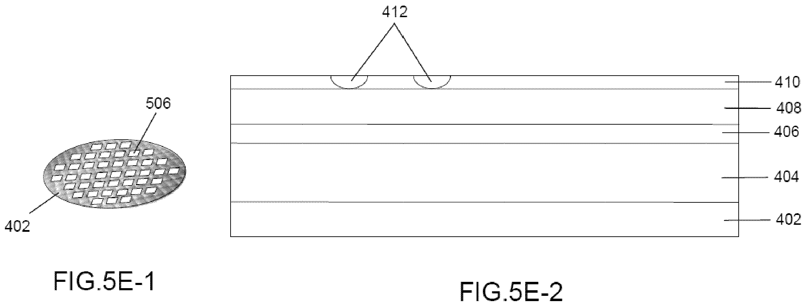

FIG. 5E-1 shows a perspective view of the schematic diagram of the layered III-V materials of the SWIR photodiode arranged on the silicon-based ROIC substrate 402 with the second silicon substrate 510 and adhesive 512/514 removed. FIG. 5E-2 shows a cross-sectional view of the schematic diagram of the layered III-V materials of the SWIR photodiode arranged on the silicon-based ROIC substrate 402 with the second silicon substrate 510 and adhesive 512/514 removed.

That is, the coupons comprising the layered III-V materials of the SWIR photodiode are transferred to the silicon-based ROIC substrate 402 from the substrate on which they are grown.

This methodology, in which the III-V materials form the SWIR photodiode are formed on the wafer 501 (a 300 mm silicon wafer) is advantageous compared to fabricating the III-V stack on an InP wafer for bonding to a silicon wafer (e.g., the silicon-based ROIC substrate 402). This is beneficial because it allows for the use of a 300 mm silicon wafer rather than the size limited InP wafer. In other words, full 300 mm compatibility is provided. Moreover, the transfer from the wafer 501 (that of the first silicon substrate 502) to the third silicon wafer (the silicon-based ROIC substrate 402), via the intermediate second silicon wafer (that of the second silicon substrate 510), avoids a step of fabricating the III-V stack directly on the silicon-based ROIC substrate 402, which can have a lower thermal tolerance. That is, higher temperatures can be used when fabricating the III-V heterostructure, without risking any damage to the silicon-based ROIC substrate 402. Furthermore, this methodology allows for access to Zn diffusion (i.e., with the high thermal budget required) on III-V SWIR imagers on silicon.

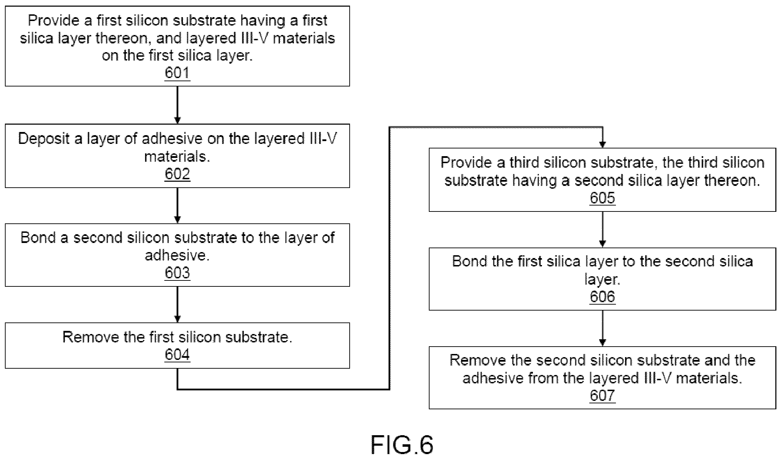

FIG. 6 is a flow chart of a semiconductor device fabrication method that corresponds to the semiconductor device fabrication methods described with reference to FIGS. 2A to 2F and 5A to 5E.

At step 601, a first silicon substrate is provided, having a first silica layer thereon, and layered III-V materials on the first silica layer.

At step 602, a layer of adhesive is deposited on the layered III-V materials.

At step 603, a second silicon substrate is bonded to the layer of adhesive.

At step 604, the first silicon substrate is removed.

At step 605, a third silicon substrate is provided, the third silicon substrate having a second silica layer thereon.

At step 606, the first silica layer is bonded to the second silica layer.

At step 607, the second silicon substrate and the adhesive are removed from the layered III-V materials.

Although the foregoing description has been set out with reference to particular examples, it is to be understood that these examples are merely illustrative of the principles and applications of the present disclosure. It is therefore to be understood that numerous modifications can be made to the illustrative examples and that other arrangements can be devised without departing from the spirit and scope of the disclosure as determined based upon the claims and any equivalents thereof.

## Claims

1. A semiconductor device (100) comprising:
a silicon substrate (102) having a silica layer (104) thereon; and
one or more laser structures (106) on the silica layer, wherein the one or more laser structures comprise layered III-V materials, and the layered III-V materials comprise an n-type doped InP layer (110) on the silica layer, a quantum well layer (112) on the n-type doped InP layer, a p-type doped InP layer (114) on the quantum well layer, and a p-type doped InGaAs layer (116) on the p-type doped InP layer;
wherein the one or more laser structures further comprise a semi-insulating III-V material (118) extending at least partially along and at least partially surrounding the quantum well layer, the p-type doped InP layer and the p-type doped InGaAs layer; and
wherein one or more photonic components (126, 128) are arranged in the silica layer, and the one or more photonic components comprise at least one of: a modulator or a germanium photodiode.

2. The semiconductor device of claim 1, wherein the modulator is a silicon-based modulator.

3. The semiconductor device of any preceding claim, wherein the one or more laser structures are buried in an encasing layer (108) arranged on the silica layer.

4. The semiconductor device of any preceding claim, wherein the one more photonic components arranged in the silica layer further comprise one or more waveguides (122) disposed in a position aligned with and below the one or more laser structures in the silica layer in a direction toward the silicon substrate.

5. The semiconductor device of any preceding claim, wherein the modulator is a PN junction modulator.

6. The semiconductor device of any preceding claim, wherein the one or more laser structures are a plurality of laser structures configured as a coarse wavelength division multiplexer.

7. A semiconductor device (400) comprising:
a silicon substrate (402) having a silica layer (404) thereon, wherein the silicon substrate is a silicon-based readout integrated circuit substrate; and
a short-wavelength infrared photodiode structure on the silica layer, wherein the short-wavelength infrared photodiode comprises layered III-V materials, wherein the layered III-V materials comprise:
a first InP layer (406) on the silica layer;
an InGaAs layer (408) on the first InP layer;
a second InP layer (410) on the InGaAs layer; and
one or more InP regions (412) embedded in the second InP layer;
wherein the first InP layer has heavy n-type doping, the second InP layer has light n-type doping, and the one or more InP regions have heavy p-type doping.

8. A semiconductor device fabrication method, the method comprising:
providing (601) a first silicon substrate having a first silica layer thereon, and layered III-V materials on the first silica layer;
depositing (602) a layer of adhesive on the layered III-V materials;
bonding (603) a second silicon substrate to the layer of adhesive;
removing (604) the first silicon substrate;
providing (605) a third silicon substrate, the third silicon substrate having a second silica layer thereon;
bonding (606) the first silica layer to the second silica layer; and
removing (607) the second silicon substrate and the adhesive from the layered III-V materials.

9. The semiconductor device fabrication method of claim 8, wherein the layered III-V materials form one or more laser structures.

10. The semiconductor device fabrication method of claim 9, wherein the layered III-V materials forming the one or more laser structures comprise:
an n-type doped InP layer on the first silica layer;
a quantum well layer on the n-type doped InP layer;
a p-type doped InP layer on the quantum well layer; and
a p-type doped InGaAs layer on the p-type doped InP layer.

11. The semiconductor device fabrication method of any one of claims 8 to 10, wherein one or more photonic components are arranged in the second silica layer, and the one or more photonic components comprise at least one of: a modulator or a germanium photodiode.

12. The semiconductor device fabrication method of claim 11, wherein the one or more photonic components arranged in the second silica layer further comprise one or more waveguides.

13. The semiconductor device fabrication method of claim 8, wherein the third silicon substrate is a silicon-based readout integrated circuit substrate, and the plurality of III-V material layers form a short-wavelength infrared photodiode, wherein the plurality if III-V material layers comprise:
a first InP layer on the first silica layer;
an InGaAs layer on the first InP layer;
a second InP layer on the InGaAs layer; and
one or more InP regions embedded in the second InP layer;
wherein the first InP layer has heavy n-type doping, the second InP layer has light n-type doping, and the one or more InP regions have heavy p-type doping.

14. The semiconductor device fabrication method of any one of claims 8 to 13, wherein bonding the first silica layer to the second silica layer comprises bonding the first silica layer to the second silica layer with hydrophilic wafer bonding.

15. The semiconductor device fabrication method of any one of claims 8 to 14, wherein removing the first silicon substrate comprises selectively etching the first silicon substrate from the first silica layer, and the method further comprises planarizing the first silica layer after the first silicon substrate is etched from the first silica layer.
